# EUROPEAN PATENT SPECIFICATION

(11) **EP 1 204 003 B1**
(45) Date of publication and mention of the grant of the patent: **23.07.2008**
(21) Application number: 00123444.2
(22) Date of filing: 03.11.2000
(51) Int. Cl.: G03F 7/30, G03F 7/32

(54) **Process for developing exposed radiation-sensitive printing plate precursors**
Verfahren zum Entwickeln belichteter strahlungsempfindlicher Druckplattenvorläufer
Procédé pour le développement de précurseurs de plaques d'impression photosensibles et exposées

(43) Date of publication of application: 08.05.2002
(73) Proprietor: Kodak Graphic Communications GmbH, 37520 Osterode/Harz (DE)
(72) Inventor: Timpe, Hans-Joachim, Prof. Dr., 37520 Osterode (DE); Fiebag, Ulrich, 31688 Nienstädt (DE)
(74) Representative: Vossius & Partner

(56) References cited:
- EP-A- 0 405 986
- EP-A- 0 490 515
- EP-A- 0 716 347
- EP-A- 1 037 116
- EP-A- 1 081 554
- DE-A- 3 921 564
- DE-A- 4 411 176
- US-A- 5 853 963

## Description

This invention relates to a process for developing imagewise exposed radiation-sensitive devices; in particular it relates to a process for developing exposed radiation-sensitive devices where the efficiency of the partially exhausted alkaline developer is lower than it appears from the measured electrical conductivity. Furthermore, the invention relates to a method for the production of a replenisher composition useful for refreshing a partially exhausted alkaline developer as well as a composition useful as a replenisher for partially exhausted alkaline developers having a lower efficiency than it appears from the measured electrical conductivity.

The art of lithographic printing is based upon the immiscibility of oil and water, in which oily material or ink is preferentially retained by the image areas and the water or fountain solution is preferentially retained by the non-image areas of the printing plate. When a suitably prepared surface is moistened with water and an ink is applied, the background or non-image areas retain the water and repel the ink while the image areas accept the ink and repel the water. The ink on the image areas is then transferred to the surface of a material upon which the image is to be reproduced, such as paper, cloth and plastics. Commonly, the ink is transferred to an intermediate material called the blanket which in turn transfers the ink to the surface of the material upon which the image is to be reproduced.

Lithographic printing plates can be either negative-working or positive-working, and comprise one or more radiation-sensitive layers on a suitable substrate, such as metal or polymeric support. The radiation-sensitive layer generally includes one or more radiation-sensitive components that may be dispersed in a suitable binder. Alternatively, the radiation-sensitive component can also be the binder material.

In order to obtain a printing plate with imagewise distribution of printable areas it is necessary to remove the non-image areas of an exposed printing plate precursor. The most common method for removing the undesired areas is to contact the exposed precursor with a developer solution.

A negative-working printing plate generally has a light sensitive layer composed of a radiation-sensitive component such as an unsaturated resin, a negative diazo resin dissolved in a polymeric binder or an initiator system together with monomers and/or oligomers on a suitable substrate. Upon exposure to light, the exposed areas are hardened, leaving non-exposed areas removable during development. Certain negative-working printing plates contain novolac resins, a cross-linking agent, and a radiation-sensitive component that produces acid on exposure. By subsequently heating the plate, only the exposed areas are cured and the unexposed areas can be removed by a developer. The exposed, hardened areas are therefore oleophilic and will accept ink while the non-exposed underlying areas of the substrate are hydrophilic.

Many alkaline developable positive-working printing plates generally have a light sensitive layer comprising a novolac resin and a radiation-sensitive component such as an *o*-diazoquinone or diazonaphthoquinone compound. Upon exposure to light the radiation-sensitive component is converted to the corresponding carboxylic acid. The use of an alkaline developer will remove only the exposed areas of the radiation-sensitive layer, leaving the surface of the support. Because the surface of the support is hydrophilic, the uncovered non-image area attracts water and repels the oily ink. The image area remaining after development is oleophilic thereby repelling water and attracting the printing ink.

Various aqueous solutions are known for use as developers. Yamasue, U.S. Pat. No. 4,259,434, describes use of a dispersion of a silicate to develop positive-working printing plates. These solutions include alkali metal silicates, in which the ratio of SiO₂ to M₂O is from 0.5 to 0.75 ("M" being the alkali metal) at 1-4% SiO₂ concentration.

Seino, U.S. Pat. No. 4,452,880 describes silicate-containing developers in which the SiO₂ to alkali metal oxide ratios are much higher, that is between 1.6 and 2.0, and the % SiO₂ concentration is from 2 to 9%.

Miller, U.S. Pat. No. 5,851,735, discloses an aqueous alkaline developing composition that is useful in developing either positive-working or negative-working lithographic printing plates. The composition has a pH of at least 12 and comprises an alkali metal silicate and at least 6 wt.-% of a water-soluble or water-dispersible thickener, such as glycerol.

Toyama, GB-A-2,276,729 (DE-A-4 411 176) discloses a developer or replenisher for both positive-working and negative-working lithographic printing plates comprising an alkali metal silicate and a water-soluble ethylene oxide adduct, obtained by addition of ethylene oxide to a sugar alcohol having not less than 4 hydroxy groups. This developer is stable and shows a high developing efficiency.

In the development of exposed printing plate precursors the problem arises that the developer is weakened by increasing m² of the developed plate; in the case of alkaline developers this means that the alkalinity of the developer decreases with increasing square meters of developed plates. The weakening of the developer leads to a darker or fuller image reproduction which does not meet the requirements for a standardized printing. In the case of conventional printing plates, i.e. plates which are imagewise exposed to radiation through a mask, the change of efficiency of the developer and therefore of the image reproduction can be monitored by simultaneously copying test elements. Of course this is not possible in the case of digital plates directly exposed by means of a laser without using a mask. If the developer has a measurable electrical conductivity, as it is usually the case with aqueous alkaline developers, the users often monitor the electrical conductivity of the used developer in order to determine the efficiency of the developer. As soon as a weakening of the developer efficiency is established by means of a lower electrical conductivity the developer is refreshed by adding a fresh developer or so-called replenisher (which has a higher concentration of hydroxide ions than the developer) to the weakened developer until the electrical conductivity of the developer again reaches its original value.

As described in EP-A-0 556 690 the electrical conductivity of a developer does not always decrease when the alkalinity decreases due to the development of plates. Depending on the kind of developer system and also on the kind of plate to be developed the electrical conductivity of the developer may be constant, may increase or decrease with increasing square meters of developed plates although the efficiency of the developer decreases in each case. According to one theory it is assumed that ingredients of the removed radiation-sensitive layer of the developed plates and/or side reactions are responsible for the production of new ions which at least partially compensate or even overcompensate the loss of electrical conductivity due to consumption of OH⁻ ions of the developer thus resulting in a measured electrical conductivity which is not as low as it would be expected due to the consumption of OH- by the developing process. Measuring the electrical conductivity does therefore not in every case allow a conclusion on the efficiency (i.e. activity) of the developer; constant values therefore do not guarantee a constant developer activity required for the desired constant developing result.

If there is a developer system and/or plate where the activity of the developer decreases while the electrical conductivity only slightly decreases, keeps constant or even increases the addition of a highly alkaline replenisher for increasing the activity results in an increase of the electrical conductivity.

EP-A-1 037 116 discloses monitoring the development process by measuring electrical conductivity and hydroxide concentration.

EP-A-0 556 690 discloses a computer controlled system for refreshing the partially exhausted developer for those cases where the value of the electrical conductivity is not a measure for the activity of the developer: This system, however, in view of the printers has the disadvantage that further expenses are necessary due to the purchase of the computer controlled system.

EP-A-405986 discloses replenisher compositions comprising an alkaline component such as sodium metasilicate and surfactants.

Therefore, there is a need for a process which does not result in the necessity of new equipment and is easy to be carried out by the printers and even unskilled workers.

The present invention provides a simple method for the production of a replenisher composition useful for refreshing an at least partially exhausted developer having a lower activity than it appears from the electrical conductivity.

The method of claim 1 comprises the steps of
(a) measuring the activity and electrical conductivity versus unit throughput of device to be processed while using the desired developer
(b) determining the amount of hydroxide ions per unit throughput necessary for achieving the original activity
(c) for the case that the electrical conductivity per unit throughput does not decrease as it should decrease due to consumption of OH⁻, determining the amount of a electrical conductivity suppressing agent necessary for keeping the electrical conductivity constant, wherein the electrical conductivity suppressing agent is water soluble, does not react with the other components of the replenisher and developer and does not react with or attack the radiation-sensitive layer of the device to be developed, and
(d) mixing water and the hydroxide ion source with the conductivity suppressing agent and optional further components.

The present invention also provides a method for developing radiation-sensitive imagewise exposed devices by using an alkaline developer showing electrical conductivity according to claim 8 comprising the steps of
(a) preparing a replenisher according to the method of claims 1-7
(b) entering the exposed devices into the developer bath and removing the devices after the desired dwell time
(c) correcting the electrical conductivity of the partially exhausted developer bath by adding a replenisher to the developer, and optionally
(d) repeating steps (b) and (c) at least once.

The present invention deals with the problem of different behavior of electrical conductivity of a developer and its activity, especially the case that the electrical conductivity does not decrease to the same extend as the activity decreases when developing a plurality of devices. The method provided herewith allows the developing of exposed radiation-sensitive devices like lithographic printing plates with constant activity of the developer without the need of a computer controlled system. According to the present invention a partially exhausted alkaline developer is refreshed by the addition of a strong alkaline replenisher which comprises an agent capable of suppressing the electrical conductivity of the developer to some extend.

According to the method of the present invention the behaviour of the activity and the electrical conductivity of the developer versus unit throughput of device to be processed are determined. Unit throughput can for instance be square meter throughput or a number of devices of a certain size.

The activity of the developer refers to the alkalinity of the developer, which is usually determined by titration with HCl (for instance 0.5 N HCI).

From the correlation of activity and unit throughput one can calculate the amount of hydroxide ions per unit throughput necessary for keeping the activity constant. In case of lithographic printing plates the replenisher used for adding the needed amount of hydroxide ions preferably contains a hydroxide ion source selected from at least one compound selected from alkali metal hydroxides, alkali metal silicates, water glass, and alkali metal phosphates in such a concentration that about 25 to 200 mL, preferably 30 to 60 mL, of replenisher per m² of developed printing plate are sufficient for replacing the consumed OH⁻ in the developer. An amount lower than about 25 mL is not preferred since per m² of developed printing plate about 25 mL of developer are removed from the developing bath with the plate and the content of the developer bath should be kept approximately constant. An amount higher than about 100 mL is not preferred from an economical point of view since by doing so the amount of waste drastically increases.

In a preferred embodiment a constant amount of replenisher is added after every processed device. In a continuous developing process it is, however, also possible to add a different amount of replenisher after a different amount of processed device, as long as the amount of replenisher is for instance doubled if the amount of throughput (e.g. in m²) is doubled.

The starting developer can but does not necessarily contain the suppressing agent.

According to one embodiment the process of the present invention the starting developer also contains the electrical conductivity suppressing agent used in the replenisher, however, in a much lower concentration, for example 0.15 to 0.5 times of the concentration used in the replenisher, more preferred 0.2 to 0.3 times.

The electrical conductivity suppressing agent is a polar organic substance which is water soluble. Furthermore, it has to be inert, i.e. it does neither react with the other components of the replenisher or the developer nor react with or attack the radiation-sensitive layer of the device to be developed.

The electrical conductivity suppressing agent used in the method as defined in claim 1 is preferably selected from glycerol, diols, mono- or diethers of diols, esters of diol monoethers, ketones substituted with at least one hydroxy group and/or alkoxy group, ethers, alkanol amines, alkanols and amides of organic acids.

Examples for suitable diols are for instance those represented by the following formula

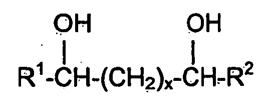

Wherein x is 0 or an integer from 1 to 4 and R¹ and R² are each independently selected from hydrogen and C₁-C₃ alkyl. Especially preferred diols are ethylene glycol, hexylene glycol, hexane-1,6-diol, propane-1,3-diol and butane-1,4-diol.

Also suitable are mono- and diethers obtained from said diols and C₁-C₄ alkanols, like methoxy propanol and 1,2-dimethoxy ethan.

Such monoethers can additionally be esterified with an organic acid selected from formic and acetic acid.

Further suitable electrical conductivity suppressing agents are ketones substituted with at least one hydroxy group and/or alkoxy group like methoxyacetone and diacetone alcohol.

Ethers of the following formula are further examples of suitable electrical conductivity suppressing agents

R³-O-R⁴

wherein R³ and R⁴ are independently selected from alkyl groups having 1 to 4 carbon atoms.

Especially preferred are cyclic ethers, i.e. ethers where R³ and R⁴ together with the oxygen atom to which they are bonded form a 5 or 6 membered ring.

Preferably the ether is 1,4-dioxane, methyl butyl ether and tetrahydrofuran.

Examples of suitable alkanol amines are those represented by the following formula:

R⁵ₘ-N-(-CH₂-CH R⁶-OH)ₙ

wherein m is 0, 1 or 2, n is 1, 2 or 3, m+n=3, R⁵ and R⁶ are each independently H or C₁-C₂ alkyl.

Especially preferred are monoethanol amine, diethanolamine, mono (isopropanol) amine and tri(isopropanol)amine.

C₃-C₆-Alkanols can also be used. The alkyl moiety can be a straight chain or branched chain alkyl as well as a cycloalkyl. The hydroxy group may be bonded to a terminal carbon atom or may be bonded to a carbon atom within the carbon skeleton. Suitable examples are butanol-2 and isopropanol.

Furthermore, the C₃-C₆ alkanols may further contain an amino group -NH₂; examples thereof are ethanolamine and propanolamine.

In addition, amides of organic acids represented by the following formula can be used as electrical conductivity suppressing agent in the method of the present invention 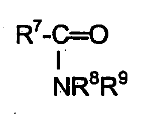 wherein R⁷ is selected from hydrogen, methyl or ethyl, R⁸ and R⁹ are each independently H or C₁-C₃ alkyl.

From the above-mentioned suppressing agents the following are especially preferred: ethylene glycol, hexane-1,6-diol.

The kind of suppressing agent useful for a certain developing process depends - beside other factors - from the kind of radiation-sensitive layer on the device to be developed since it is important that the suppressing agent does not attack said layer.

The amount of the electrical conductivity suppressing agent in the replenisher depends on the developer composition as well as the kind of radiation sensitive layer to be developed. In most cases the amount is suitably in the range of about 2 to about 15 wt.-% based on the total replenisher composition, more preferably from about 4 to about 11 wt.-%.

Besides the electrical conductivity suppressing agent the replenisher comprises water and at least one component selected from alkali metal hydroxides (like lithium hydroxide, sodium hydroxide, potassium hydroxide and ammonium hydroxide), alkali metal metasilicates, water glass, alkali metal phosphates, alkali metal carbonates and hydrogen carbonates, or alkali metal borates in order to provide sufficient alkalinity. In order to be able to increase the alkalinity of a partially exhausted developer it is necessary that the amount of the hydroxide, metasilicate, water glass, phosphates, carbonates, hydrogen carbonates and/or borates in the replenisher is distinctly higher than in the developer; preferably the amount in the replenisher is 1.2 to 1.6 times as high as in the developer.

It is preferred that the alkalinity of the replenisher is 1.2 to 1.6 times as high as that of the original developer; furthermore, the electrical conductivity of the replenisher is preferably also higher than that of the original developer (e.g 1.1 to 1.5 times as high as that of the original developer).

Optionally the replenisher further comprises at least one member selected from surfactants, etch inhibitors, antifoaming agents, chelating agents and biocides.

Examples of chelating agents include polyphosphoric acids and their sodium, potassium and ammonium salts; aminopolycarboxylic acids, such as ethylenediaminetetraacetic acid, diethylenetriaminepentaacetic acid, triethylenetetraaminehexaacetic acid, hydroxyethylethylenediaminetriacetic acid, nitrilotriacetic acid, 1,2-diaminocyclohexanetetraacetic acid, 1,3-diamino-2-propanoltetraacetic acid, etc., and their sodium, potassium and ammonium salts; aminotri(methylenephosphonic acid), ethylenediaminetetra(methylenephosphonic acid), diethylenetriaminepenta(methylenephosphonic acid), triethylenetetraminehexa(methylenephosphonic acid), hydroxyethylethylenediaminetri(methylenephosphonic acid) and 1-hydroxyethane-1,1-diphosphonic acid, and their sodium, potassium and ammonium salts.

Preferred chelating agents which simultaneously also act as etch inhibitors are phoshonic acid derivatives like those represented by the formula 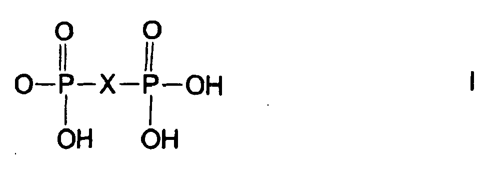 in which X is C₂-C₆ alkylene or 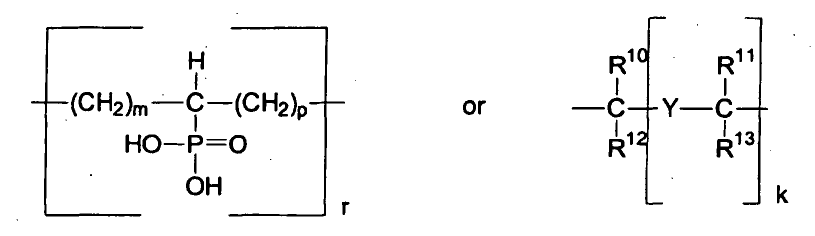 in which k = 0 or 1; m = 1, 2, 3; p = 1, 2, 3; r is an integer from 10-20; R¹⁰ and R¹¹ are each independently H or C₁-C₄ alkyl; R¹² and R¹³ are each independently H, OH or C₁-C₄ alkoxy; and Y is -R⁹N-(CH₂)ₙ-(NR⁸)_{q}-, in which q = 0 or 1, n is an integer from 0 to 8 and R⁸ and R⁹ are each independently H, C₁-C₄ alkyl or -CH₂-P(O)(OH)₂.

Especially preferred are hydroxyethane diphosphonic acid, aminotri(methylenephosphonic acid), hexamethylene diaminotetra(methylenephosphonic acid), sodium salts thereof, and mixtures thereof.

The amount of the chelating agent or mixture of the chelating agents is from 0 to 5 wt.-% based on the total composition of the replenisher.

Examples of the surfactant which can be used include nonionic surfactants, such as polyoxyethylene alkyl ethers, polyoxyethylene alkyl phenyl ethers, polyoxyethylene polystyryl phenyl ethers, polyoxyethylenepolyoxypropylene alkyl ethers, glycerin fatty acid partial esters, sorbitan fatty acid partial esters, pentaerythritol fatty acid partial esters, propylene glycol monofatty acid esters, cane sugar fatty acid partial esters, polyoxyethylenesorbitan fatty acid partial esters, polyoxyethylenesorbitol fatty acid partial esters, polyethylene glycol fatty acid esters, polyglycerin fatty acid partial esters, polyoxyethylenized castor oils, polyoxyethyleneglycerin fatty acid partial esters, fatty acid diethanolamides, N,N-bis-2-hydroxyalkylamines, polyoxyethylene alkylamines, triethanolamine fatty acid esters, and trialkylamine oxides; anionic surfactants, such as fatty acid salts, abietic acid salts, hydroxyalkanesulfonic acid salts, alkanesulfonic acid salts, dialkylsulfosuccinic acid esters, straight-chain alkylbenzenesulfonic acid salts, branched alkylbenzenesulfonic acid salts, alkylnaphthalenesulfonic acid salts, alkylphenoxypolyoxyethylenepropylsulfonic acid salts, polyoxyethylene alkyl sulfophenyl ethers, N-methyl-N-oleyltaurin sodium salt, N-alkylsulfosuccinic acid monoamide disodium salts, petroleum sulfonic acid salts, sulfated beef-tallow oil, sulfates of fatty acid alkyl esters, alkylsulfuric acid esters, polyoxyethylene alkyl ether sulfuric acid esters, fatty acid monoglyceride sulfuric acid esters, polyoxyethylene alkyl phenyl ether sulfuric acid esters, polyoxyethylene styryl phenyl ether sulfuric acid esters, alkylphosphoric acid esters, polyoxyethylene alkyl ether phosphoric acid esters, polyoxyethylene alkyl phenyl ether phosphoric acid esters, partially saponified styrene/maleic anhydride copolymers, partially saponified olefin/maleic anhydride copolymers, and formaldehyde condensates of naphthalenesulfonates; cationic surfactants such as alkylamine salts, quaternary ammonium salts, polyoxyethylene alkylamine salts, and polyethylene polyamine derivatives, and amphoteric surfactants, such as carboxybetaines, aminocarboxylic acids, sulfobetaines, aminosulfuric acid esters, and imidazolines. The polyoxyethylene moiety present in some of the above-cited surfactants can be replaced by a polyoxypropylene, polyoxybutylene or another polyoxyalkylene moiety, and the resulting surfactants also can be included.

Further suitable surfactants are fluorinated surfactants in which a perfluoroalkyl group is present. Examples of such fluorinated surfactants include anionic ones, such as perfluoroalkylcarboxylic acid salts, perfluoroalkylsulfonic acid salts, perfluoroalkylphosphoric acid esters, etc.; amphoteric ones, such as perfluoroalkylbetaines, etc.; cationic ones, such as perfluoroalkyltrimethylammonium salts, etc.; and nonionic ones, such as perfluoroalkylamine oxides, perfluoroalkylethylene oxide adducts, oligomers containing perfluoroalkyl and hydrophilic groups, oligomers containing perfluoroalkyl and lipophilic groups, oligomers containing perfluoroalkyl, hydrophilic and lipophilic groups, and urethanes containing perfluoroalkyl and lipophilic groups.

Preferred surfactants are sulfonic acid salts, sulfuric acid esters and compounds containing perfluoroalkyl groups.

The surfactant can be used alone or as a mixture of two or more thereof. The concentration of such a surfactant in the replenisher is generally from 0 to 10% by weight, preferably from 0.01 to 5% by weight.

Further, the replenisher can further contain one or more antifoaming agent if desired. Suitable antifoaming agents are for instance polydimethylsiloxanes or their copolymers. They are used in an amount of 0 to 1 wt.-% based on the total replenisher, more preferably of 0.01 to 0.5 wt.-%.

Examples of suitable etch inhibitors are for instance 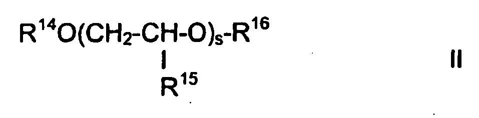 In which R¹⁴ is hydrogen or C₁-C₄ alkyl; R¹⁵ is hydrogen, methyl or ethyl; R¹⁶ is hydrogen or CH₂COOH; and s is an integer from 10 to 20.

They are used in an amount of 0 to 3 wt.-% based on the total weight of the replenisher composition, preferably 0.001 to 0.6 wt.-%.

Further suitable etch inhibitors are alkali metal phosphates and polyphosphates, and phosphonates.

The method of the present invention is especially suitable for developing positive working thermal plates comprising a radiation-sensitive layer which comprises
(a) at least one polymeric substance which is a phenolic resin soluble in an aqueous developer, is,
(b) at least one compound which reduces the developer solubility of the polymeric substance and is selected from imidazolium compounds, quinolinium compounds, benzothiazolium compounds and pyridinium compounds with quinolinium compounds being preferred and
(c) at least one compound which is capable of absorbing radiation and converting it to heat and is selected from one of the following classes: squarylium, merocyanine, indolizine, pyrylium and metal dithioline.

Such printing plates are described in EP-B-0 825 927.

In an especially preferred embodiment of the invention a replenisher is used which comprises
(a) at least one of alkali metal hydroxide and water glass,
(b) at least one phosphonic acid derivative selected from hydroxyethanediphosphonic acid, aminotri(methylenephosphonic acid), hexamethylenediaminotetra-(methylenephosphonic acid), sodium salts thereof, and mixtures thereof,
(c) at least one polyglycol derivative selected from polypropylene glycol ether, polyethylene glycol ether, polybutylene glycol ether, derivatives thereof, and mixtures thereof, and
(d) 8-15 wt.-% based on the total weight of the replenisher composition of a electrical conductivity suppressing agent selected from ethylene glycol and hexane-1,6-diol, and diacetone alcohol.

Any commonly used developing equipment can be used for carrying our the process according to the present invention.

The invention is now described in more details by the examples below

### Reference example 1

### Preparation of replenisher 1

A replenisher was prepared from the following components under stirring:

| | |
|---|---|
| 69.7 kg | water |
| 19.1 kg | potassium hydroxide solution 45 wt.-% in water |
| 2.1 kg | phosphoric acid 85 wt.-% in water |
| 6.1 kg | potassium waterglass 42/43 degrees Be in water |
| 13 kg | ethylene glycol |
| 0.21 kg | REWOTERIC® AM-V (wetting agent available from Witco) |
| 0.21 kg | Sequion 10 Na (sodium salt of hydroxyethane diphosphonic acid) |
| 0.24 kg | Synperonic T 304 (ICI Corp.) |

and the mixture was subsequently filtered. It was stored in a closed container prior to use.

### Example 1

### Preparation of replenisher 2

A replenisher was prepared from the following components under stirring:

| | |
|---|---|
| 74 kg | water |
| 11.0 kg | sodium hydroxide solution 50 wt.-% in water |
| 2.0 kg | phosphoric acid 85 wt.-% in water |
| 8.6 kg | sodium waterglass 37/40 degrees Be in water |
| 3.7 kg | hexane-1,6-diol |
| 0.18 kg | Trilon® B (tetrasodium salt of EDTA, available from BASF) |
| 0.14 kg | Synperonic T 304 |

and the mixture was subsequently filtered. It was stored in a closed container prior to use.

### Reference Example 2

### Preparation of developer 1:

A developer was prepared from the following components under stirring:

| | |
|---|---|
| 40.9 kg | water |
| 5.8 kg | potassium hydroxide solution 45 wt.-% in water |
| 1.1 kg | phosphoric acid 85 wt.-% in water |
| 3.2 kg | potassium waterglass 42/43 degrees Be in water |
| 1.5 kg | glycerol |
| 0.1 kg | REWOTERIC® AM-V |
| 0.1 kg | Sequion 10 Na |
| 0.12 kg | Synperonic T 304 |

and the mixture was subsequently filtered. It was stored in a closed container prior to use.

### Reference Example 3

### Preparation of developer 2:

A developer was prepared from the following components under stirring:

| | |
|---|---|
| 41.3 kg | water |
| 3.8 kg | sodium hydroxide solution 50 wt.-% in water |
| 1.1 kg | phosphoric acid 85 wt.-% in water |
| 4.8 kg | sodium waterglass 37/40 degrees Be in water |
| 0.9 kg | hexane-1,6-diol |
| 0.1 kg | Trilon B |
| 0.08 kg | Synperonic T 304 |

and the mixture was subsequently filtered. It was stored in a closed container prior to use.

### Reference Example 4

### Preparation of developer 3:

A developer was prepared which differed from developer 1 in that no glycerol was present and 42.4 kg water were used instead of 40.9 kg.

### Comparative Example 1

### Prepararation of Comparative replenisher 1:

A replenisher was prepared from the following components under stirring:

| | |
|---|---|
| 72.3 kg | water |
| 19.1 kg | potassium hydroxide solution 45 wt.-% in water |
| 2.1 kg | phosphoric acid 85 wt.-% in water |
| 6.1 kg | potassium waterglass 42/43 degrees Be in water |
| 0.21 kg | REWOTERIC® AM-V |
| 0.21 kg | Sequion 10 Na |
| 0.24 kg | Synperonic T 304 |

and the mixture was subsequently filtered. It was stored in a closed container prior to use.

### Comparative Example 2

### Prepararation of Comparative replenisher 2:

A replenisher was prepared which differed from replenisher 1 in that no ethylene glycol was present and 82.7 kg water were used instead of 69.7 kg.

### Example 2

### Developing of positive-working thermal plate

The positive-working printing plate Electra® used in the following examples is available from Kodak Polychrome Graphics LLC. Electra® plates were cut to a size of 515 x 790 mm and exposed in the IR-exposure unit Trendsetter 3244 (from Creo/Heidelberg) using an energy of 10 W and a rotational speed of the drum of 180 rpm. The Kodak Professional Colorflow Strip (available from Eastman Kodak), which contains different elements for evaluating the quality of the copies was used for evaluation.

A commercially available processor (Sprinter; Kodak Polychrome Graphics LLC), equipped with an immersion type developing bath, a section for rinsing with water, and a gumming and drying section, was used to develop the imagewise exposed plates. The processor was filled with 20L of the appropriate developer. Separately, a container for the replenisher was attached from which a predetermined amount of replenisher per square meter of developed plate was added to the developing bath via a pump.

The following other processor parameters were kept constant in all tests:

| | |
|---|---|
| temperature of the developing bath | (23±1)°C |
| dwell time in the developer | 45 sec |

The electrical conductivity of the developing bath was monitored by a separately mounted electrical conductivity measuring unit of the type Conductivity Monitor (Unigraph). To determine the activity (i.e. the alkali content) 10 mL of the developer were removed from the developing bath, 90 mL deionized water were added, and titration was carried out with 0.5 N HCI (Titrino DMS 716. Metrohm). The number of mL used to reach the first equivalence point is referred to as alkali value.

To evaluate the copies obtained after development, the following criteria were examined:

Reproduction of the 1 and 2 pixel elements, optical density (OD) of the checkerboard dots of the pixel elements (measured with the apparatus D 19C/D 196 from Gretag/Macbeth).

### Stability and load tests

Electra® plates exposed in the manner described above were developed one after another at a rate of 33 plates per day for 30 days (plus 5 weekend interruptions) in the Sprinter processor. The quality of the resulting copies was evaluated in terms of the criteria given above. At a throughput of 2 m²/L the electrical conductivity was measured as well as the activity (by titration with 0.5 N HCI).

The results for replenisher 1 and developer 1 are listed in Table 1 below. The titration and electrical conductivity data show that the electrical conductivity as well as the activity of the developer can be kept constant during the long testing period by the addition of replenisher in the amount of 50 mL per m² of developed plate. This also becomes apparent in the almost constant values for the copy parameters after the development of 400 m² dots of 1 x 1 pixel elements were open independently from the throughput.

During the test period of 12 L of overflow of used developer was collected, which corresponds to about 30 mL/m² of processed printing plates. No formation of foam or precipitation was observed during the testing period. After the test was completed, the processor could be easily cleaned by rinsing with water, and no residue remained.

Neither ink acceptance nor toning problems occurred in printing tests of plates after different throughputs.

The procedure was repeated with Electra® plates and developer 2 and replenisher 2. It was found that by adding 49 mL of replenisher 2, the activity of the developer could be kept constant until the end of the testing at 18 m²/L (electrical conductivity: 52.6 mS/cm; titration: 7.8 mL). Also, the copy parameters of OD = 95 for 95% dot screen and OD = 49 for 59% dot screen in the beginning only slightly changed to OD = 96 and OD = 51, respectively, after a plate throughput of 18 m²/L. Plates developed with such a developing system showed no problems in ink acceptance or toning during the printing test at the print proof and upon restarting.

**Table 1**

| Throughput (m²/L) | Replenisher (mL/m²) | Optical Density (95% dot) | Optical Density (50% dot) | Electrical conductivity (mS/cm) | Titration (mL 0.5 N HCl) |
|---|---|---|---|---|---|
| 0 | | 95 | 51 | 72.9 | 8.9 |
| 2 | 50 | 96 | 50 | 72.7 | 8.8 |
| 4 | 50 | 95 | 51 | 72.6 | 8.5 |
| 6 | 50 | 96 | 50 | 72.4 | 8.5 |
| 8 | 50 | 95 | 50 | 72.8 | 8.6 |
| 10 | 50 | 95 | 51 | 72.9 | 8.7 |
| 12 | 50 | 96 | 51 | 72.5 | 8.4 |
| 14 | 50 | 95 | 50 | 72.8 | 8.5 |
| 16 | 50 | 95 | 51 | 72.6 | 8.4 |
| 18 | 50 | 96 | 51 | 72.4 | 8.6 |
| 20 | 50 | 96 | 50 | 72.5 | 8.4 |

### Example 3

### Influence of organic compounds on electrical conductivity of replenisher solutions

A replenisher solution was prepared from the following components under stirring:

| | |
|---|---|
| 7.0 kg | water |
| 2.0 kg | potassium hydroxide solution 45 wt.-% in water |
| 0.2 kg | phosphoric acid 85 wt.-% in water |
| 0.6 kg | potassium waterglass 42/43 degrees Be in water |
| 0.02 kg | REWOTERIC® AM-V |
| 0.02 kg | Sequion 10 Na |
| 0.02 kg | Synperonic T 304 |

The electrical conductivity of this solution was monitored by a electrical conductivity measuring unit of the type Conductivity Monitor (Unigraph). The electrical conductivity of this solution was 180 mS/cm. By addition of definitive amounts of compounds listed in Table 2 several solutions, containing different wt.-% of these compounds, were prepared, and their electrical conductivity was measured by the same way, The results are given in Table 2. It is shown that all used polar organic compounds depress the electrical conductivity of the replenisher solution, however, to a different extent.

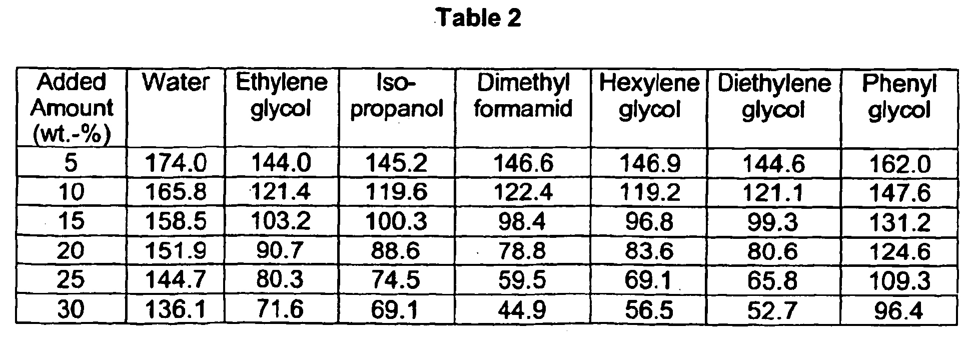

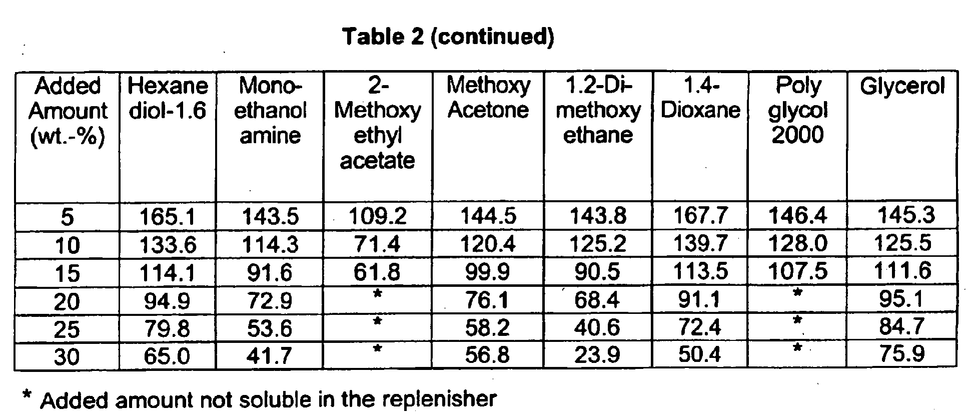

### Comparative Example 3

### Stability and load tests with compositions of Comparative Example 1

Electra® plates were developed in the same manner as described above in the developing processor with the developer 3 and the replenisher listed in Comparative Example 1. Compared to replenisher solution 1, this replenisher contains no conductivity suppressing agent. The procedures to determine the plate quality and developer activity are identical with these of the above given load tests.

These tests provide the following results:

At a replenishment rate of 40 mL/m², the electrical conductivity parameter remained constant. The activity of the developer, however, decreased with the number of loaded plates leading to an unacceptable plate quality, see Table 3 below.

**Table 3**

| Throughput (m²/L) | Replenisher (mL/m²) | Optical Density (95% dot) | Optical Density (50% dot) | Electrical conductivity (mS/cm) | Titration (mL 0.5 N HCl) |
|---|---|---|---|---|---|
| 0 | | 96 | 49 | 89.0 | 8.9 |
| 2 | 40 | 96 | 50 | 88.9 | 8.7 |
| 4 | 40 | 95 | 51 | 89.2 | 8.5 |
| 6 | 40 | 96 | 52 | 89.3 | 8.4 |
| 8 | 40 | 97 | 50 | 89.2 | 8.2 |
| 10 | 40 | 96 | 52 | 89.1 | 8.0 |
| 12 | 40 | 97 | 51 | 89.2 | 7.9 |
| 14 | 40 | 97 | 52 | 89.3 | 7.7 |
| 16 | 40 | 98 | 52 | 89.1 | 7.5 |
| 18 | 40 | 98 | 53 | 89.3 | 7.4 |
| 20 | 40 | 99 | 53 | 89.2 | 7.2 |

At a replenishment rate of 50 mL/m², the activity of the developer remained constant. The electrical conductivity parameter, however, increased with the number of loaded plates. Due to the constant developer activity the plate quality parameters also remain constant, see Table 4 below. As is apparent from Tables 3 and 4 it is not possible to infer the activity of the developer from the measurement of the electrical conductivity.

**Table 4**

| Throughput (m²/L) | Replenisher (mL/m²) | Optical Density (95% dot) | Optical Density (50% dot) | Electrical conductivity (mS/cm) | Titration (mL 0.5 N HCl) |
|---|---|---|---|---|---|
| 0 | | 95 | 48 | 89.1 | 8.8 |
| 2 | 50 | 96 | 47 | 90.7 | 8.6 |
| 4 | 50 | 95 | 47 | 92.0 | 8.7 |
| 6 | 50 | 95 | 49 | 93.1 | 8.6 |
| 8 | 50 | 96 | 47 | 94.6 | 8.5 |
| 10 | 50 | 96 | 48 | 95.5 | 8.4 |
| 12 | 50 | 95 | 47 | 96.9 | 8.6 |
| 14 | 50 | 95 | 49 | 98.3 | 8.5 |
| 16 | 50 | 96 | 47 | 99.5 | 8.4 |
| 18 | 50 | 95 | 49 | 101.2 | 8.5 |
| 20 | 50 | 96 | 47 | 102.9 | 8.6 |

The above tests clearly show that a determination of the developer activity by means of electrical conductivity is only possible if a sufficient amount of electrical conductivity suppressing agent is present in the replenisher solution.

### Comparative Example 4

Electra® plates were developed in the same manner as described above in Example 3 by using developer 3.

At a replenishment rate of 50 mL/m² of the comparative replenisher 2 the measured electrical conductivity continually increased while the activity of the developer bath remained constant.

### Example 4

Electra® plates were developed in the same manner as described above in Example 3 by using developer 3.

At a replenishment rate of 50 mL/m² of the replenisher 1 the measured electrical conductivity as well as the activity of the developer bath remained constant.

### Example 5

Electra® plates were developed in the same manner as described above in Example 3 by using developer 3.

At a replenishment rate of 50 mL/m² of the replenisher 2 the measured electrical conductivity as well as the activity of the developer bath remained constant.

## Claims

1. A method for the production of a replenisher composition useful for refreshing a partially exhausted developer having a lower activity than it appears from the electrical conductivity, comprising the steps:
(a) measuring the activity and electrical conductivity versus unit throughput of device to be processed while using the desired developer
(b) determining the amount of hydroxide ions per unit throughput necessary for achieving the original activity
(c) for the case that the electrical conductivity per unit throughput does not decrease as it should decrease due to consumption of OH⁻, determining the amount of a electrical conductivity suppressing agent necessary for keeping the electrical conductivity constant, wherein the electrical conductivity suppressing agent is water soluble, does not react with the other components of the replenisher and developer and does not react with or attack the radiation-sensitive layer of the device to be developed
(d) mixing water and the hydroxide ion source with the electrical conductivity suppressing agent and optional further components.

2. The method according to claim 1, wherein the replenisher comprises besides the electrical conductivity suppressing agent:
at least one component selected from alkali metal hydroxides, alkali metal metasilicate, water glass and alkali metal phosphates as hydroxide ion source
and optionally at least one member selected from phosphonic acids and derivatives thereof, surfactants, polyglycols, anti-foaming agents, chelating agents and biocides.

3. The method according to claim 1 or 2, wherein the electrical conductivity suppressing agent is selected from diols, mono- or diethers of diols, esters of diol monoethers, ketones substituted with at least one hydroxy group or alkoxy group, ethers, alkanol amines, alkanols and amides of organic acids.

4. The method according to claim 3, wherein the electrical conductivity suppressing agent is selected from ethylene glycol, hexylene glycol, diethylene glycol, polyethylene glycol, polypropylene glycol, hexane-1,6-diol, isopropanol, monoethanol amine, methoxy acetone, 1,2-dimethoxy ethane, 1,4-dioxane, 2-methoxy ethyl acetate, dimethyl formamide.

5. The method according to any one of claims 1 to 4, wherein the amount of electrical conductivity suppressing agent in the replenisher is in the range from about 2 to about 15 wt.-% based on the total composition.

6. Method according to any one of claims 1 to 5, wherein the alkalinity of the replenisher is 1.2 to 1.6 times as high as that of the original developer.

7. Method according to any one of claims 1 to 6, wherein the electrical conductivity of the replenisher is 1.1 to 1.5 times as high as that of the original developer.

8. A method for developing radiation-sensitive imagewise exposed devices by using an alkaline developer showing electrical conductivity, comprising the steps of
(a) preparing a replenisher according to the method of claims 1 to 7
(b) entering the exposed devices into the developer bath and removing the devices after the desired dwell time
(c) adding the replenisher to the partially exhausted developer bath in order to obtain the original activity of the developer, and optionally
(d) repeating steps (b) and (c) at least once.

9. Method according to claim 8, wherein a constant amount of replenisher is added to the partially exhausted developer per unit of processed device.

10. Method according to claim 8 or 9, wherein the device to be processed is an imagewise exposed lithographic printing plate precursor.

11. Method according to claim 10, wherein the alkalinity and the amount of the electrical conductivity suppressing agent in the replenisher is such that the alkalinity and the conductivtiy of the developer can be kept constant by adding 30 to 60 mL replenisher per unit of processed lithographic printing plate precursor to the developer

12. Replenisher composition comprising
(a) at least one component selected from alkali metal hydroxide, alkali metal metasilicate, water glass and alkali metal phosphates
(b) at least one electrical conductivity suppressing agent selected from the group consisting of hexylene glycol, diethylene glycol, hexane-1,6-diol, isopropanol, methoxy acetone, diaceton alcohol, 1,2-dimethoxy ethane, methoxypropanol, 1,4-dioxane, 2-methoxy ethyl acetate, dimethyl formamide
and optionally
(c) at least one member selected from phosphonic acids and derivatives thereof, surfactants, polyglycols, anti-foaming agents, chelating agents and biocides.

13. Composition according to claim 12, having a pH of 10 to 14.

14. Composition according to claim 12 or 13, wherein the amount of electrical conductivity suppressing agent is in the range from 2 to 15 wt.-% based on the total composition.

15. Use of a composition as defined in any of claims 12 to 14 for refreshing a partially exhausted developer.

## Patentansprüche

1. Verfahren zur Herstellung einer Regeneratzusammensetzung, nützlich zum Auffrischen eines teilweise erschöpften Entwicklers mit einer niedrigeren Aktivität als es von der elektrischen Leitfähigkeit erscheint, umfassend die Schritte:
(a) Messen der Aktivität und elektrischen Leitfähigkeit gegen Einheit Durchsatz der zu verarbeitenden Vorrichtung bei Verwendung des gewünschten Entwicklers
(b) Bestimmen der zum Erreichen der ursprünglichen Aktivität notwendigen Menge an Hydroxidionen pro Einheit Durchsatz
(c) für den Fall, dass sich die elektrische Leitfähigkeit pro Einheit Durchsatz nicht so verringert, wie sie sich aufgrund des Verbrauchs von OH⁻ verringern sollte, Bestimmen der zum Konstanthalten der elektrischen Leitfähigkeit notwendigen Menge eines Mittels zum Drücken der elektrischen Leitfähigkeit, wobei das Mittel zum Drücken der elektrischen Leitfähigkeit wasserlöslich ist, nicht mit anderen Komponenten des Regenerats und des Entwicklers reagiert und nicht mit der strahlungsempfindlichen Schicht der zu entwickelnden Vorrichtung reagiert oder diese angreift
(d) Mischen von Wasser und der Hydroxidionenquelle mit dem Mittel zum Drücken der elektrischen Leitfähigkeit und gegebenenfalls weiteren Komponenten.

2. Verfahren gemäß Anspruch 1, wobei das Regenerat neben dem Mittel zum Drücken der elektrischen Leitfähigkeit umfasst:
mindestens eine Komponente, ausgewählt aus Alkalimetallhydroxiden, Alkalimetallmetasilikaten, Wasserglas und Alkalimetallphosphaten als Hydroxidionenquelle
und gegebenenfalls mindestens ein Mitglied, ausgewählt aus Phosphonsäuren und Derivaten davon, grenzflächenaktiven Mitteln, Polyglykolen, Entschäumern, Chelatbildnern und Biociden.

3. Verfahren gemäß Anspruch 1 oder 2, wobei das Mittel zum Drücken der elektrischen Leitfähigkeit ausgewählt ist aus Diolen, Mono- oder Diethern von Diolen, Estern von Diolmonoethern, Ketonen, welche mit mindestens einer Hydroxylgruppe oder Alkoxygruppe substituiert sind, Ethern, Alkanolaminen, Alkanolen und Amiden von organischen Säuren.

4. Verfahren gemäß Anspruch 3, wobei das Mittel zum Drücken der elektrischen Leitfähigkeit ausgewählt ist aus Ethylenglykol, Hexylenglykol, Diethylenglykol, Polyethylenglykol, Polypropylenglykol, Hexan-1,6-diol, Isopropanol, Monoethanolamin, Methoxyaceton, 1,2-Dimethoxyethan, 1,4-Dioxan, 2-Methoxyethylacetat, Dimethylformamid.

5. Verfahren gemäß einem der Ansprüche 1 bis 4, wobei die Menge des Mittels zum Drücken der elektrischen Leitfähigkeit im Regenerat im Bereich von etwa 2 bis etwa 15 Gew.-%, bezogen auf die gesamte Zusammensetzung, ist.

6. Verfahren gemäß einem der Ansprüche 1 bis 5, wobei die Alkalinität des Regenerats 1,2 bis 1,6 mal so hoch ist wie die des ursprünglichen Entwicklers.

7. Verfahren gemäß einem der Ansprüche 1 bis 6, wobei die elektrische Leitfähigkeit des Regenerats 1,1 bis 1,5 mal so hoch ist wie die des ursprünglichen Entwicklers.

8. Verfahren zum Entwickeln von strahlungsempfindlichen bildweise belichteten Vorrichtungen unter Verwendung eines alkalischen Entwicklers, der elektrische Leitfähigkeit zeigt, umfassend die Schritte:
(a) Herstellen eines Regenerats gemäß dem Verfahren der Ansprüche 1 bis 7,
(b) Einbringen der belichteten Vorrichtungen in das Entwicklungsbad und Entnehmen der Vorrichtungen nach der gewünschten Verweilzeit,
(c) Hinzufügen des Regenerats zu dem teilweise erschöpften Entwicklerbad, um die ursprüngliche Aktivität des Entwicklers zu erhalten, und gegebenenfalls
(d) mindestens einmal Wiederholen der Schritte (b) und (c).

9. Verfahren gemäß Anspruch 8, wobei eine konstante Menge des Regenerats zu dem teilweise erschöpften Entwickler pro Einheit der verarbeiteten Vorrichtung zugefügt wird.

10. Verfahren gemäß Anspruch 8 oder 9, wobei die zu verarbeitende Vorrichtung ein Vorläufer einer bildweise belichteten lithographischen Druckplatte ist.

11. Verfahren gemäß Anspruch 10, wobei die Alkalinität und die Menge des Mittels zum Drücken der elektrischen Leitfähigkeit in dem Regenerat so gewählt ist, dass die Alkalinität und die Leitfähigkeit des Entwicklers durch Zufügen von 30 bis 60 ml Regenerat pro Einheit des verarbeiteten Vorläufers der lithographischen Druckplatte zu dem Entwickler konstant gehalten werden können.

12. Regeneratzusammensetzung umfassend
(a) mindestens eine Komponente, ausgewählt aus Alkalimetallhydroxid, Alkalimetallmetasilikat, Wasserglas und Alkalimetallphosphaten
(b) mindestens ein Mittel zum Drücken der elektrischen Leitfähigkeit, ausgewählt aus Hexylenglykol, Diethylenglykol, Hexan-1,6-diol, Isopropanol, Methoxyaceton, Diacetonalkohol, 1,2-Dimethoxyethan, Methoxypropanol, 1,4-Dioxan, 2-Methoxyethylacetat, Dimethylformamid und gegebenenfalls
(c) mindestens ein Mitglied, ausgewählt aus Phosphonsäuren und Derivaten davon, grenzflächenaktiven Mitteln, Polyglykolen, Entschäumern, Chelatbildnern und Biociden.

13. Zusammensetzung gemäß Anspruch 12 mit einem pH-Wert von 10 bis 14.

14. Zusammensetzung gemäß Anspruch 12 oder 13, wobei die Menge des Mittels zum Drücken der elektrischen Leitfähigkeit im Bereich von 2 bis 15 Gew.-%, bezogen auf die gesamte Zusammensetzung, ist.

15. Verwendung einer Zusammensetzung wie in einem der Ansprüche 12 bis 14 definiert zum Auffrischen eines teilweise erschöpften Entwicklers.

## Revendications

1. Procédé de production d'une composition de régénération utile pour la régénération d'un révélateur partiellement épuisé dont l'activité est inférieure à celle que présente la conductivité électrique, comprenant les étapes suivantes :
a) la mesure de l'activité et de la conductivité électrique en fonction de l'unité de production du dispositif devant être traité tout en utilisant le révélateur souhaité
b) la détermination de la quantité d'ions hydroxyde par unité de production nécessaire pour atteindre l'activité initiale
c) pour le cas où la conductivité électrique par unité de production ne diminue pas en raison de la consommation d'OH⁻, la détermination de la quantité d'agent suppresseur de conductivité électrique nécessaire pour maintenir une conductivité électrique constante, dans laquelle l'agent suppresseur de conductivité électrique est soluble dans l'eau, ne réagit pas avec les autres constituants de la solution de régénération et le révélateur et ne réagit pas avec, ou n'attaque pas, la couche sensible aux rayonnements du dispositif devant être développé
d) le mélange de l'eau et de la source d'ions hydroxyde avec l'agent suppresseur de conductivité électrique et d'autres composants optionnels.

2. Procédé selon la revendication 1, dans lequel la solution de régénération comprend en plus de l'agent suppresseur de conductivité électrique :
au moins un constituant choisi parmi les hydroxydes de métal alcalin, les métasilicates de métal alcalin, les silicates de sodium et les phosphates de métal alcalin comme source d'ions hydroxyde
et éventuellement, au moins un élément choisi parmi les acides phosphoniques et les dérivés de ceux-ci, les agents tensio-actifs, les polyglycols, les agents anti-mousse, les agents chélatants et les biocides.

3. Procédé selon la revendication 1 ou 2, dans lequel l'agent suppresseur de conductivité électrique est choisi parmi les diols, les monoéthers ou diéthers de diols, les esters des monoéthers de diols, les cétones substituées par au moins un groupe hydroxy ou un groupe alcoxy, les éthers, les alcanolamines, les alcanols et les amides d'acides organiques.

4. Procédé selon la revendication 3, dans lequel l'agent suppresseur de conductivité électrique est choisi parmi l'éthylène glycol, l'hexylène glycol, le diéthylène glycol, le polyéthylène glycol, le polypropylène glycol, l'hexane-1,6-diol, l'isopropanol, la monoéthanolamine, la méthoxyacétone, le 1,2-diméthoxyéthane, le 1,4-dioxane, l'acétate de méthoxy-2 éthyle, le diméthylformamide.

5. Procédé selon l'une quelconque des revendications 1 à 4, dans lequel la quantité d'agent suppresseur de conductivité électrique dans la solution de régénération est comprise dans la plage allant de 2 à 15 % en poids environ, par rapport à la composition totale.

6. Procédé selon l'une quelconque des revendications 1 à 5, dans lequel l'alcalinité de la solution de régénération est 1,2 à 1,6 fois plus élevée que celle du révélateur initial.

7. Procédé selon l'une quelconque des revendications 1 à 6, dans lequel la conductivité électrique de la solution de régénération est 1,1 à 1,5 fois plus élevée que celle du révélateur initial.

8. Procédé permettant de développer les dispositifs exposés conformément à l'image sensibles aux rayonnements en utilisant un révélateur alcalin présentant une conductivité électrique, comprenant les étapes de
a) préparation d'une solution de régénération selon le procédé des revendications 1 à 7
b) entrée des dispositifs exposés dans le révélateur et le retrait des dispositifs suite au temps de maintien souhaité
c) addition de la solution de régénération au révélateur partiellement épuisé afin d'obtenir l'activité initiale du révélateur, et éventuellement
d) répétition des étapes b) et c) au moins une fois.

9. Procédé selon la revendication 8, dans lequel une quantité constante de solution de régénération est incorporée au révélateur partiellement épuisé pour chaque unité du dispositif traité.

10. Procédé selon la revendication 8 ou 9, dans lequel le dispositif devant être traité est un précurseur de plaque d'impression lithographique exposé conformément à l'image.

11. Procédé selon la revendication 10, dans lequel l'alcalinité et la quantité d'agent suppresseur de conductivité électrique dans la solution de régénération sont telles que l'alcalinité et la conductivité du révélateur peuvent être maintenues constantes en incorporant au révélateur 30 à 60 mL de solution de régénération pour chaque unité du précurseur de plaque d'impression traité.

12. Composition de régénération comprenant
a) au moins un constituant choisi parmi les hydroxydes de métal alcalin, les métasilicates de métal alcalin, les silicates de sodium et les phosphates de métal alcalin
b) au moins un agent suppresseur de conductivité électrique choisi parmi le groupe constitué de l'hexylène glycol, le diéthylène glycol, l'hexane-1,6 diol, l'isopropanol, la méthoxyacétone, l'alcool diacétonique, le 1,2-diméthoxyéthane, le méthoxypropanol, le 1,4-dioxane, l'acétate de méthoxy-2 éthyle, le diméthylformamide et éventuellement
c) au moins un élément choisi parmi les acides phosphoniques et les dérivés de ceux-ci, les agents tensio-actifs, les polyglycols, les agents anti-mousse, les agents chélatants et les biocides.

13. Composition selon la revendication 12, ayant un pH allant de 10 à 14.

14. Composition selon la revendication 12 ou 13, dans laquelle la quantité d'agent suppresseur de conductivité électrique est comprise dans la plage allant de 2 à 15 % en poids, par rapport à la composition totale.

15. Utilisation d'une composition telle que définie dans l'une quelconque des revendications 12 à 14 permettant de régénérer un révélateur partiellement épuisé.
